(19) Europäisches Patentamt
European Patent Office
Office européen des brevets

(11) EP 1 760 883 B1

(12) FASCICULE DE BREVET EUROPEEN

(45) Date de publication et mention
de la délivrance du brevet:
**05.05.2010 Bulletin 2010/18**

(51) Int Cl.:
***H03K 3/537*** *(2006.01)*

(21) Numéro de dépôt: **06291369.4**

(22) Date de dépôt: **29.08.2006**

(54) **Elément d'un dispositif d'accumulation d'énergie et générateur associé**

Element einer Energiespeichervorrichtung und zugehöriger Generator

Element of an energie accumulating device and associated generator

(84) Etats contractants désignés:
**DE FR GB SE**

(30) Priorité: **30.08.2005 FR 0508839**

(43) Date de publication de la demande:
**07.03.2007 Bulletin 2007/10**

(73) Titulaire: **Institut Franco-Allemand de Recherches de**
**Saint-Louis**
**68301 Saint Louis Cedex (FR)**

(72) Inventeurs:
• **Charon, Romain**
**68730 Michelbach-Le-Bas (FR)**

• **Raymond, Pierre**
**68990 Heimsbrunn (FR)**

(74) Mandataire: **Le Moenner, Annie**
**Bureau de la Propriété Industrielle**
**DGA/DSP/SDAG/BPI**
**16 bis Avenue Prieur de la Côte d'Or**
**94114 Arcueil Cedex (FR)**

(56) Documents cités:
**FR-A- 2 098 513     FR-A- 2 569 319**
**FR-A- 2 622 044     FR-A- 2 823 033**

## Description

La présente invention concerne le domaine des condensateurs notamment en vue de leur application dans un générateur haute tension d'impulsions, de type MARX comprenant un grand nombre de condensateurs connectés électriquement en parallèle, des résistances de charge connectées en série et des éclateurs, de telle sorte que la tension d'entrée charge en parallèle les condensateurs et que ceux-ci se déchargent en série via les éclateurs.

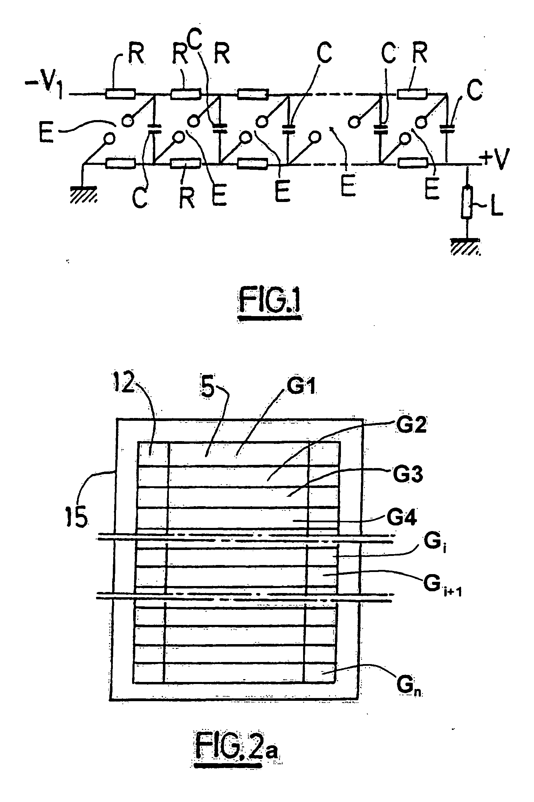

La figure 1 représente le schéma électrique d'un générateur de type MARX. Sur cette figure $C_T$ désigne des condensateurs, R des résistances de charge et E des éclateurs comportant chacun deux demi-éclateurs.

Les condensateurs $C_T$, chargés en parallèle à la tension d'entrée V1 sont mis en série à l'aide d'éclateurs E.

Si n est le nombre d'étages ou le nombre de condensateurs $C_T$, l'amplitude de l'impulsion de la tension V2 appliquée à la charge L est égale à :

$$V_2 = nV_1$$

Si on désigne par $C_T$ la capacité d'un condensateur (ou d'un étage), la capacité équivalente de l'ensemble du générateur de MARX est égale à C/n. L'énergie stockée est égale à :

$$W = n\left(1/2\ C_T\ V_1{}^2\right)$$

Après l'impulsion de déclenchement, les condensateurs $C_T$ sont déchargés en série via les éclateurs E.

L'impulsion de déclenchement est appliquée sur une électrode auxiliaire uniquement présente sur le premier éclateur. Les tensions aux bornes de chaque condensateur $C_T$ sont mises en série, donc s'additionnent.

On connaît la demande FR2823033 qui décrit un générateur haute tension d'impulsions, de type MARX comprenant un grand nombre de condensateurs connectés électriquement en parallèle, des résistances de charge connectées en série et des éclateurs, de telle sorte que la tension d'entrée charge en parallèle les condensateurs et que ceux-ci se déchargent en série via les éclateurs. Ce générateur est constitué par un bloc compact cylindrique comprenant des galettes superposées, chaque galette, aussi appelée étage, comportant plusieurs condensateurs connectés électriquement avec des résistances de charge et avec deux demi-éclateurs, l'ensemble étant noyé dans une résine isolante d'enrobage. De plus, chaque galette comprend au moins une série de condensateurs juxtaposés de façon à former une couronne, chaque condensateur formant un secteur de ladite couronne, les condensateurs étant reliés de chaque coté à une plaque conductrice ou à des circuits imprimés haute tension. Chacun des deux demi-éclateurs d'un même étage forme un éclateur avec un demi éclateur de l'étage adjacent aval pour l'un, et avec un demi-éclateur de l'étage adjacent amont pour l'autre.

Ce concept de galette permet de réaliser un générateur de Marx modulaire dont la tension de sortie maximale est définie par le nombre d'étages, donc de galettes superposées. En outre, la conception spécifique de ces étages est telle que les éclateurs sont disposés dans un canal central contenant un gaz sous pression et permettant leur déclenchement simultané. Ce phénomène d'avalanche est amélioré par effet photoélectrique lié à la forte production de rayonnement ultraviolet au moment de la décharge électrique au niveau des éclateurs.

L'énergie stockée dans un tel générateur dépend d'une part des caractéristiques physiques des condensateurs et du nombre d'étages du générateur et, d'autre part de la tension de charge appliquée à chacun des étages. Or augmenter la taille des condensateurs ou du nombre d'étages accroît l'encombrement du générateur tandis que l'augmentation de la tension de charge provoque un phénomène de claquage en surface par contournement mettant en court circuit l'étage correspondant.

Le but de l'invention est de résoudre ces problèmes en proposant un générateur haute tension d'impulsions permettant de stocker davantage d'énergie que les générateurs existants et ne présentant pas de risque de claquage en surface par contournement.

Un générateur selon la demande de brevet FR2823033 présente aussi l'inconvénient de ne pas pouvoir être réalisé lorsqu'on ne dispose pas d'installation d'enrobage.

Le but de l'invention est aussi de résoudre cet inconvénient en proposant des éléments d'un dispositif d'accumulation d'énergie ne nécessitant éventuellement pas d'enrobage lors de la fabrication du générateur.

La solution apportée est un élément d'un dispositif d'accumulation d'énergie comportant au moins un condensateur revêtu, individuellement ou non, d'un enrobage et caractérisé en ce que l'enrobage à une forme extérieure de secteur tronqué.

Ainsi, on peut constituer un générateur notamment de type Marx, en simplement juxtaposant des éléments selon l'invention de façon à former une galette en forme de couronne et en les connectant à une résistance de charge et à deux demi-éclateurs, puis en superposant des galettes ainsi formées. Il n'est ainsi plus nécessaire d'enrober les condensateurs lors de la fabrication du générateur, les condensateurs étant chacun pré-enrobés en usine lors de leur fabrication

Selon une caractéristique additionnelle permettant d'optimiser la quantité d'énergie apte à être stockée, l'élément comporte au moins un condensateur ayant une forme de secteur tronqué.

Selon une caractéristique particulière au moins une gorge ou un canal est ménagé dans l'enrobage, cette gorge ou ce canal ayant préférentiellement deux extrémités qui débouchent sur la même face de l'ensemble, en l'occurrence sur la face tronquée du secteur formé par ledit ensemble.

Ainsi, un tel élément peut être utilisé dans un générateur comprenant des galettes superposées $G_1$, $G_2$, $G_3$, $G_4$... $G_i$..., comportant chacune au moins un condensateurs C connecté à une résistance de charge R et à deux demi-éclateurs ($e_{1i}$, $e_{2i}$), le générateur comportant ainsi des éclateurs (E) formés par deux demi-éclateurs ($e_{1i+1}$ et $e_{2i}$) dont l'un est connecté au dit au moins un condensateur C appartenant à la galette $G_i$ et l'autre au dit au moins un condensateur C appartenant à la galette $G_{i+1}$, caractérisé en ce qu'un solide (20) est disposé entre au moins deux demi-éclateurs ($e_{1i+1}$, $e_{2i}$) d'un éclateur (E), les extrémités qui débouchent de ladite gorge devant se trouver de part et d'autre du solide).

Selon une caractéristique additionnelle, ledit canal ou ladite gorge a une forme de U.

Selon une autre caractéristique, la face tronquée du secteur formé par ledit ensemble comporte une rainure ou des lèvres.

Selon une autre caractéristique, l'élément comporte des éléments de fixation disposés en saillie ou en retrait de la surface externe de l'enrobage et fixés ou non à une nappe souple, un clinquant ou à circuit imprimé ou une plaque conductrice, ces éléments de fixation pouvant comporter un évidement.

D'autres avantages et caractéristiques de la présente invention apparaîtront dans la description de différentes variantes de réalisation de l'invention, en regard des figures annexées parmi lesquelles :

- la figure 1 est un schéma électrique d'un générateur de MARX ;
- la figure 2a est une vue en coupe axiale schématique d'un générateur de Marx à galettes tandis que la figure 2b est une partie du schéma électrique correspondant;
- la figure 3 est une vue en plan d'une galette haute énergie d'un générateur de Marx selon un mode de réalisation de l'invention ;
- la figure 4 est une vue en coupe suivant un plan radial de la galette selon ce mode de réalisation ;
- les figures 5 et 6 concernent deux exemples de modes de réalisation des condensateurs ;
- la figure 7 est une vue en plan d'une galette haute énergie d'un générateur de Marx selon un second mode de réalisation de l'invention ;
- les figures 8a à 8f concernent des exemples de vues en coupe d'éléments d'un dispositif d'accumulation d'énergie selon l'invention ;
- la figure 9 est une vue en plan d'une galette d'un générateur de Marx selon un troisième mode de réalisation de l'invention ;
- la figure 10 concerne un autre exemple d'élément d'un dispositif d'accumulation d'énergie selon l'invention.

Comme montré sur la figure 1, un générateur haute tension d'impulsions, de type MARX comprend généralement un grand nombre de condensateurs $C_T$ connectés électriquement en parallèle, des résistances de charge R connectées en série et des éclateurs E, de telle sorte que la tension d'entrée charge en parallèle les condensateurs $C_T$ et que ceux-ci se déchargent en série via les éclateurs E. Chaque éclateur E comporte deux demi-éclateurs.

Un générateur à galettes est constitué, comme montré sur la figure 2a, par un bloc compact cylindrique comprenant des galettes superposées $G_1$, $G_2$, $G_3$, $G_4$..., aussi appelée étages.

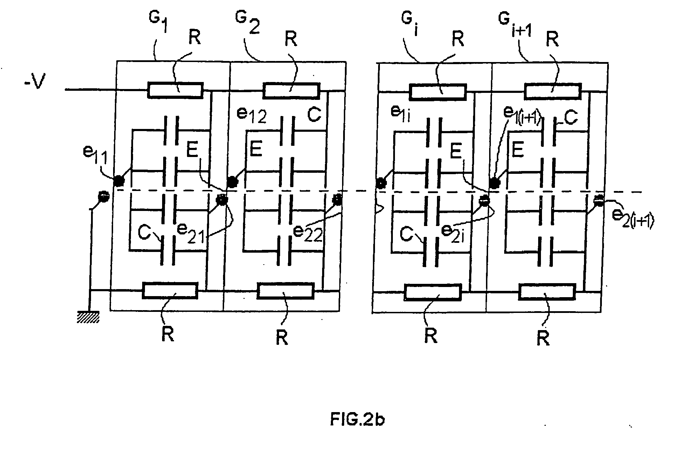

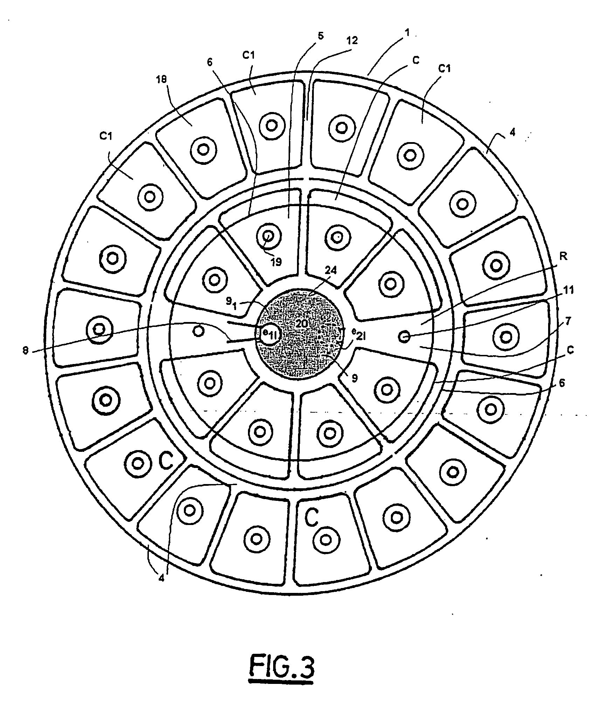

Chaque galette $G_i$ comporte, comme présenté sur les figures 2b et 3, plusieurs condensateurs C en parallèle connectés à des résistances de charge R et à deux demi-éclateurs $e_{1i}$ et $e_{2i}$, ces condensateurs étant juxtaposés de façon à former une couronne 5. L'ensemble est noyé dans une résine isolante d'enrobage 4. L'indice i des demi-éclateurs correspond à l'indice de l'étage correspondant. Pour une question de clarté, seulement quatre étages ont été représentés sur le schéma électrique de la figure 2b. Le condensateur $C_T$ de la figure 1 correspond à l'ensemble des condensateurs C présents dans un étage.

Comme montré sur la figure 2b, chaque éclateur est composé de deux demi-éclateurs $e_{1i+1}$ et $e_{2i}$, dont l'un appartient à l'étage $G_i$ et l'autre à l'étage $G_{i+1}$.

Chaque condensateur C forme un secteur de cette couronne 5. Les dimensions actuelles du secteur sont liées à des contraintes technologiques de réalisation industrielle des condensateurs.

Les condensateurs C sont reliés électriquement de chaque coté, par des éléments de fixation conducteurs 19, à une plaque conductrice 6 de forme circulaire disposée coaxialement à ladite couronne 5. Cette couronne 5 comporte deux parties diamétralement opposées 7, inoccupées par un condensateur, formant chacune un logement pour une résistance de charge R connectée électriquement à la plaque circulaire 6.

Par ailleurs, la plaque circulaire 6 porte sur sa périphérie intérieure une lame conductrice 8 faisant saillie dans un évidement circulaire central 9 de la galette. Les extrémités de ces lames 8 portent chacune un demi éclateur, respectivement $e_{1i}$ et $e_{2i}$.

De plus, les lames 8 sont raccordées à la plaque circulaire 6, dans la zone 7 inoccupée par un condensateur.

D'autre part, les deux demi-éclateurs $e_{1i}$ et $e_{2i}$ sont disposés dans l'évidement circulaire 9 et sont situées dans deux plans axialement décalés P1 et P2, l'un des demi-éclateurs étant situé au-dessus de l'autre.

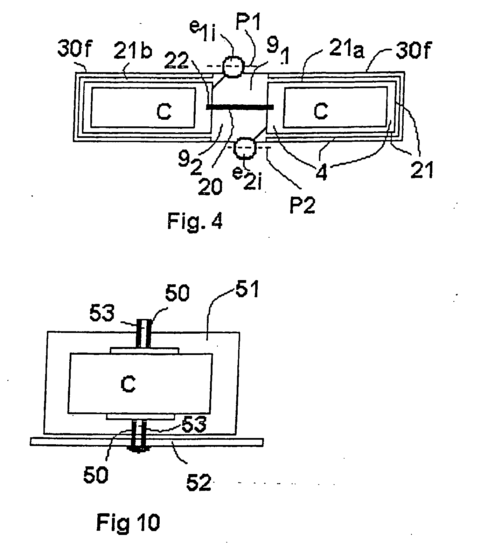

Un solide 20 est disposé entre les deux sphères demi-éclateurs $e_{1i}$ et $e_{2i}$ et séparent l'évidement circulaire en deux parties respectivement $9_1$ et $9_2$. Ce solide 20 est apte à isoler électriquement les deux demi-éclateurs $e_{1i}$ et $e_{2i}$ de l'étage $G_i$. Il est constitué par une plaque réalisée en matériau présentant une transmittance, préférentiellement supérieure à 80% dans l'ultra-violet et notamment dans la bande de fréquence comprise entre 250 et 400nm. Dans cet exemple de réalisation de l'invention, ce solide est constitué par une plaque en verre 20 ancrée, de chaque côté, dans une rainure 22 pratiquée dans l'enrobage 4 de chacune des galettes. Afin d'assurer une équipression entre les deux parties $9_1$ et $9_2$ de l'évidement circulaire 9, deux canaux diamétralement opposés 21a et 21b, présentés sur la figure 4 et dont la longueur est supérieure à celle séparant les deux demi-éclateurs $e_{1i}$ et $e_{2i}$, relient lesdites parties $9_1$ et $9_2$ de l'évidement circulaire 9.

Les galettes superposées $G_1$, $G_2$, $G_3$... sont reliées électriquement les unes aux autres par deux tiges métalliques 11 diamétralement opposées traversant les plaques conductrices 6 dans la zone 7 inoccupée par un condensateur.

Dans la réalisation de la figure 3, la série de condensateurs C disposée suivant la couronne 5 est entourée au moins par une seconde série de condensateurs C1 formant une seconde couronne 12. Les condensateurs de cette seconde série sont reliés électriquement par une plaque conductrice circulaire concentrique à celle qui relie les condensateurs C de la première série. Ils permettent d'augmenter considérablement l'énergie stockée par étage élémentaire.

Comme montré sur la figure 4 présentant le schéma d'une coupe d'un étage de condensateurs selon l'axe des canaux 21a et 21b, chaque étage est enrobé par un revêtement en résine 22 qui comporte un canal circulaire 21a et 21b contournant chacun un condensateur C. Leur longueur est suffisante pour éviter un claquage entre les deux demi-éclateurs $e_{1i}$ et $e_{2i}$ et via ledit canal 21 et compte tenu de la tension de charge et de la pression du gaz dans l'évidemment 9. On rappelle que ces deux dernières caractéristiques sont liées par la loi de Paschen qui fixe la distance des demi-éclateurs $e_{1i}$ et $e_{2i}$ et la nature du gaz dans lequel elles baignent pour une tension disruptive donnée.

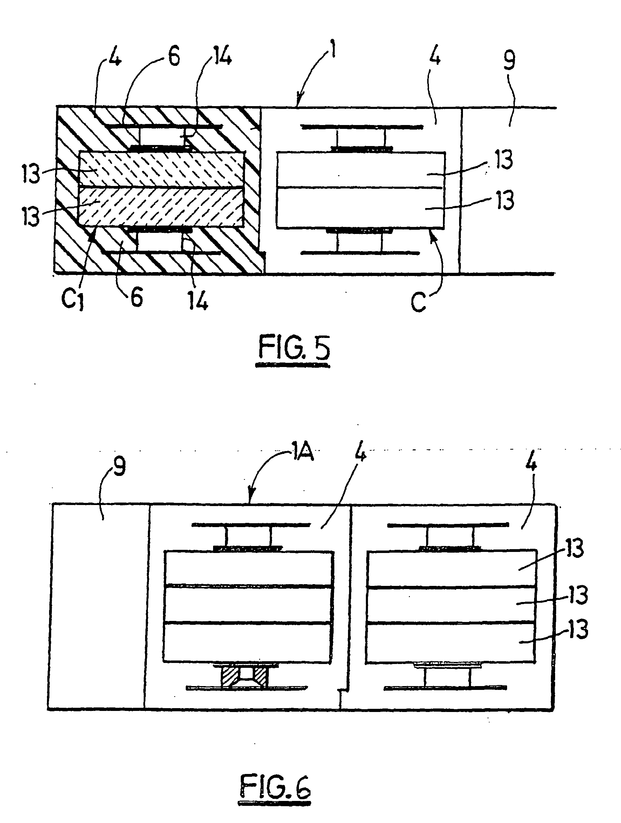

Comme indiqué sur les figures 5 et 6, chaque condensateur C, C1 comprend une ou plusieurs plaques en céramique 13 dont les faces opposées sont en contact avec des plots conducteurs 14 en contact avec une plaque conductrice 6. Dans le cas de la figure 5, chaque condensateur comprend deux plaques 13 en céramique, tandis que dans le cas de la figure 6, chaque condensateur comprend trois plaques 13 en céramique.

Dans ce dernier cas, la galette 1A a une épaisseur plus importante que la galette 1 de la figure 5.

La résine d'enrobage 4 peut être de la résine époxy.

Les galettes superposées 1,2, 3 sont contenues à l'intérieur d'une enveloppe extérieure cylindrique 15, comme montré sur la figure 2. Dans cet exemple de réalisation, cette enveloppe est en métal.

Cette enveloppe extérieure 15 peut également contenir à sa partie inférieure un convertisseur continu-continu 16 et des batteries 17 pour rendre le générateur de MARX autonome.

Les principaux avantages du générateur de MARX que l'on vient de décrire sont les suivants :

- une très forte augmentation de l'énergie stockée, par étage élémentaire, du générateur haute tension impulsionnel de type MARX,
- les dimensions des galettes centrales sont compatibles avec les précédentes générations de générateur MARX.
- Le principe peut naturellement être étendu à d'autres formes, dimensions et encombrement.

Pour la radiographie éclair très haute énergie sur chantier : un tel générateur, dans sa version autonome, permet d'envisager des applications à très haute énergie pulsée tout en maintenant l'absence de connections électriques dangereuses avec des sources haute-tension (celle-ci est intégrée), d'où une amélioration du confort et de la sécurité d'utilisation. On peut envisager une commande déportée pour le déclenchement synchronisé ou non d'un ou plusieurs générateurs de ce concept.

Cette nouvelle conception permet de réaliser des générateurs à plus faible temps de montée (self parasite très faible) particulièrement utiles pour piloter un tube hyperfréquence pour réaliser un rayonnement micro-onde ou piloter directement une antenne, via la ligne de mise en forme de l'impulsion, pour réaliser un rayonnement ultra large bande ou large bande.

Dans ce dernier cas, un surcroît d'énergie sera obtenu via les couronnes périphériques.
Cette technologie ouvre de nouvelles perspectives pour la réalisation de générateurs haute-tension pulsée pour des développeurs de lasers puissants comme pour des applications médicales voire la dépollution de fumées, la pulvérisation de matériaux durs tels que du béton ou des céramiques, la dépollution et le traitement d'eau.

Pour la fabrication des galettes précédemment décrites, plusieurs techniques peuvent être envisagées. Ainsi, on peut reprendre celle décrite dans la demande de brevet FR2823033 mais en disposant un solide entre les demi-éclateurs $e_{1i}$ et $e_{2i}$ d'une même galette et en ménageant au moins un canal 21a contournant au moins un condensateur lors de l'enrobage et/ou une rainure 22 dans l'enrobage au niveau de l'évidement circulaire 9 pour l'ancrage du solide 20.

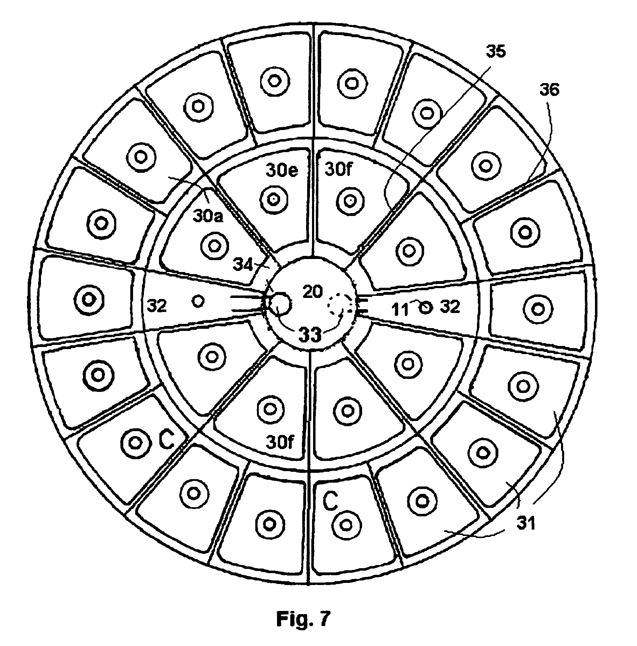

Lorsqu'une installation d'enrobage n'est pas disponible sur site, la fabrication des galettes peut être réalisée, comme montré sur la figure 7, par juxtaposition d'éléments d'un dispositif d'accumulation d'énergie selon l'invention constituant des premiers secteurs tronqués pré-enrobés 30 et 31 comportant chacun un ou plusieurs condensateurs C et de deux seconds secteurs tronqués 32 comportant chacun une résistance de charge connectée à un demi-éclateur $e_{1i}$ ou $e_{2i}$ disposé au-delà de la partie tronquée 34 du secteur 32. Ces secteurs 30 et 32 sont tronqués de façon à former une couronne présentant un évidement central 9. Dans cet exemple de réalisation, l'évidement central est de forme circulaire. Dans cet exemple de réalisation, les secteurs tronqués 30, formant avec les seconds secteurs tronqués 32 une première couronne interne 35, n'ont pas les mêmes dimensions que les secteurs tronqués 31 formant une couronne externe 36, les première et seconde couronnes étant concentriques. En effet, l'angle des premiers secteurs 31 de la couronne interne 35 est égal, dans cet exemple de réalisation, à l'angle formé par deux secteurs juxtaposés de la couronne externe 36.

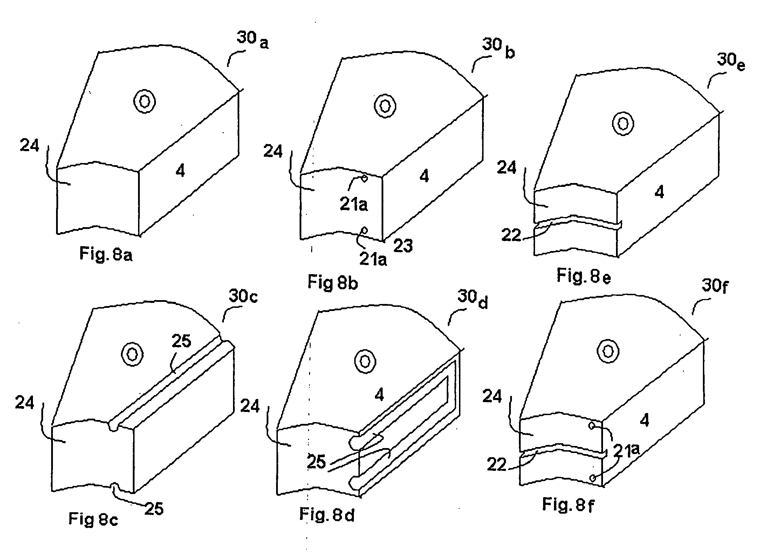

Les figures 8a, 8b et 8c montrent plusieurs exemples de réalisation des premiers secteurs tronqués 30 de la couronne interne 35, ces secteurs tronqués formant des éléments du dispositif d'accumulation d'énergie constitué par le générateur. Ces secteurs, qui peuvent comporter un ou plusieurs condensateurs, peuvent soit avoir la simple forme d'un secteur tronqué comme montré sur la figure 8a, soit comporter quelques aménagements. Ainsi, sur la figure 8b, le secteur tronqué 30b comporte en plus, par rapport à celui de la figure 8a, un canal 21a ménagé dans l'enrobage 4 dont la fonction, dans le cadre du générateur selon l'invention, est d'assurer une équipression de part et d'autre du solide 20.

Sur les figures 8c et 8d, le canal 21a est remplacé par une gorge 25 pratiquée dans l'enrobage 4 débouchant sur la face tronquée 24 du secteur et ménagée sur trois faces consécutives du secteur ou sur l'une seulement de ses faces.

Les figures 8e et 8f présentent des secteurs similaires à ceux des figures respectives 8a et 8b, mais comportant, en plus, une rainure 22 sur leur face tronquée 24. Cette rainure 22 est destinée à permettre l'ancrage d'une partie de la périphérie d'un solide 20.

Dans l'exemple illustré par la figure 7, la couronne interne 35 comporte six secteurs 30e selon la figure 8e et 2 secteurs 30f selon la figure 8f, diamétralement opposés.

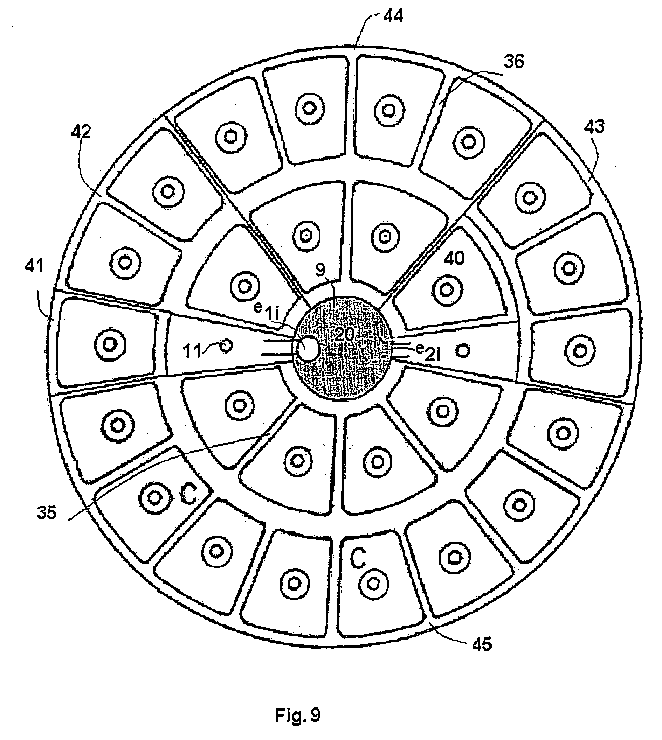

La figure 9 présente quelques exemples de secteurs tronqués différents. Ainsi :

- les secteurs 40,41, comportent un seul condensateur, le premier étant destiné à la couronne externe 36 et le second à la couronne interne 35,
- les secteurs 42,43, comportent trois condensateurs répartis sur les deux couronnes pour l'un et seulement sur la couronne externe 36 pour l'autre,
- le secteur 44 comporte six condensateurs répartis sur les deux couronnes,
- le secteur 45 comporte 12 condensateurs répartis sur les deux couronnes.

La connectique est telle que décrite dans l'exemple de réalisation des figures 2 à 6.

Toutefois un enrobage global d'une couronne ou d'un étage peut être réalisé afin de minimiser les risques de claquage par contournement par rapport à une simple juxtapositions de secteurs.

La figure 10 montre un autre exemple de connectique d'un élément d'un dispositif d'accumulation d'énergie selon l'invention dans lequel des éléments de connexion électrique à souder 50 dépassent de part et d'autre de l'enrobage 51. L'un de ces éléments peut, par exemple, être connecté à une plaque comme dans l'exemple de réalisation des figures 2 à 6 ou, par exemple, à un clinquant ou à un circuit imprimé 52. En outre, ces éléments de connexion 50 peuvent comporter un évidemment 53 afin d'éviter d'éventuels problèmes d'inertie thermique.

Bien entendu, de nombreuses modifications peuvent être apportées aux modes de réalisation précédemment décrits sans sortir du cadre de l'invention. Ainsi, le générateur peut comporter des condensateurs de différentes formes et ne pas comporter de galette circulaire mais d'une autre forme. De plus le solide entreposé entre les deux éclateurs peut avoir une forme quelconque, pourvu qu'il permette d'accroître la valeur minimale de la tension à partir de laquelle apparaît le phénomène de claquage. La fixation de ce solide entre les deux électrodes de l'éclateur peut se faire par tout moyen approprié, ces moyens pouvant être solidaires du solide, des éléments du dispositif d'accumulation d'énergie ou en partie des deux. Il peut aussi être fixé par simple pression des éléments du dispositif d'accumulation d'énergie sur le solide. En outre, les éclateurs peuvent prendre n'importe qu'elle forme convenable comportant au moins deux électrodes.

**Revendications**

1. Elément (30, 30a, 30b, 30c, 30d, 30e, 30f, 31) d'un dispositif d'accumulation d'énergie comportant au moins un condensateur (C) revêtu, individuellement ou non, d'un enrobage (4), **caractérisé en ce que** l'enrobage (4) à une forme extérieure de secteur tronqué.

2. Elément selon la revendication 1, **caractérisé en ce qu'**il comporte au moins un condensateur (C) ayant une forme de secteur tronqué.

3. Elément selon l'une quelconque des revendications 1 et 2, **caractérisé en ce qu'**au moins une gorge (25) ou un canal (21 a, 21 b) est ménagé dans l'enrobage (4).

4. Elément selon la revendication 3, **caractérisé en ce que** la gorge (25) ou le canal (21a, 21b) a deux extrémités qui débouchent sur la même face (24) de l'enrobage.

5. Elément selon la revendication 4, **caractérisé en ce que** les deux extrémités de la gorge (25) ou du canal (21 a, 21 b) débouchent sur la face tronquée (24) du secteur tronqué.

6. Elément selon l'une quelconque des revendications 3 à 5, **caractérisé en ce que** ledit canal (21 a, 21 b) ou ladite gorge (25) à une forme de U.

7. Elément selon l'une quelconque des revendications 1 à 6, **caractérisé en ce que** la face tronquée (24) du secteur tronqué comporte une rainure (22) ou des lèvres.

8. Elément selon l'une quelconque des revendication 1 à 7, **caractérisé en ce qu'**il comporte des éléments de fixation et/ou de connexion électrique (50, 19) disposés en saillie ou en retrait de la surface externe de l'enrobage (4).

9. Elément selon la revendication 8, **caractérisé en ce que** l'un des éléments de fixation et/ou de connexion électrique (50, 19 ) est fixé à une nappe souple, un clinquant ou à circuit imprimé.

10. Elément selon l'une quelconque des revendication 1 à 7, **caractérisé en ce qu'**au moins un des éléments de fixation et/ou de connexion électrique (50, 19 ) est disposé en saillie et comporte un évidemment (53).

11. Générateur de tension comportant un élément selon l'une quelconque des revendications 1 à 10.

**Claims**

1. Element (30, 30a, 30b, 30c, 30d, 30e, 30f, 31) of an energy-accumulating device including at least one capacitor (C), which is coated, individually or otherwise, with an encapsulation (4), **characterized in that** the encapsulation (4) has the external form of a truncated sector.

2. Element according to Claim 1, **characterized in that** it includes at least one capacitor (C) in the form of a truncated sector.

3. Element according to any one of Claims 1 and 2, **characterized in that** at least one groove (25) or one channel (21a, 21b) is made in the encapsulation (4).

4. Element according to Claim 3, **characterized in that** the groove (25) or channel (21a, 21b) has two ends, which open onto the same face (24) of the encapsulation.

lation.

5. Element according to Claim 4, **characterized in that** the two ends of the groove (25) or channel (21a, 21b) open onto the truncated face (24) of the truncated sector.

6. Element according to any one of Claims 3 to 5, **characterized in that** said channel (21a, 21b) or said groove (25) is U-shaped.

7. Element according to any one of Claims 1 to 6, **characterized in that** the truncated face (24) of the truncated sector has a groove (22) or lips.

8. Element according to any one of Claims 1 to 7, **characterized in that** it includes fixing and/or electrical connection elements (50, 19) which project from or are recessed into the external surface of the encapsulation (4).

9. Element according to Claim 8, **characterized in that** one of the fixing and/or electrical connection elements (50, 19) is fixed to a flexible surface, a foil or a printed circuit.

10. Element according to any one of Claims 1 to 7, **characterized in that** at least one of the fixing and/or electrical connection elements (50, 19) projects and has a recess (53).

11. Voltage generator including an element according to any one of Claims 1 to 10.

**Patentansprüche**

1. Element (30, 30a, 30b, 30c, 30d, 30e, 30f, 31) einer Energiespeichervorrichtung mit mindestens einem Kondensator (C), auf den eine Beschichtung (4) einzeln oder nicht einzeln aufgebracht wird, **dadurch gekennzeichnet, dass** die Außenform dieser Beschichtung (4) aus einem stumpfförmigen Segment besteht.

2. Element nach Anspruch 1, **dadurch gekennzeichnet, dass** dieses Element mindestens einen Kondensator (C) in Form eines stumpfförmigen Segmentes besitzt.

3. Element nach einem beliebigen der vorhergehenden Ansprüche 1 oder 2, **dadurch gekennzeichnet, dass** mindestens eine Rille (25) oder ein Kanal (21a, 21b) in die Beschichtung (4) eingebracht wird.

4. Element nach Anspruch 3, **dadurch gekennzeichnet, dass** die Rille (25) oder der Kanal (21a, 21b) zwei Enden besitzt, die zu derselben Fläche (24) der

**6**

Beschichtung führen.

5. Element nach Anspruch 4, **dadurch gekennzeichnet, dass** beide Enden der Rille (25) oder des Kanals (21a, 21b) zur abgestumpften Fläche (24) des stumpfförmigen Segmentes führen.

6. Element nach einem beliebigen der vorhergehenden Ansprüche 3 bis 5, **dadurch gekennzeichnet, dass** der Kanal (21a, 21 b) oder die Rille (25) U-förmig ist.

7. Element nach einem beliebigen der vorhergehenden Ansprüche 1 bis 6, **dadurch gekennzeichnet, dass** die abgestumpfte Fläche (24) des stumpfförmigen Segmentes eine Nut (22) oder Lippen aufweist.

8. Element nach einem beliebigen der vorhergehenden Ansprüche 1 bis 7, **dadurch gekennzeichnet, dass** sich Befestigungs- und/oder Stromanschlusselemente (50, 19) nach vorne oder nach hinten versetzt in der Außenfläche der Beschichtung (4) befinden.

9. Element nach Anspruch 8, **dadurch gekennzeichnet, dass** eines der Befestigungsund/oder Stromanschlusselemente (50, 19) an einer elastischen Isolierplatte, einer Metallfolie oder einer gedruckten Schaltung befestigt ist.

10. Element nach einem beliebigen der vorhergehenden Ansprüche 1 bis 7, **dadurch gekennzeichnet, dass** mindestens eines der Befestigungs- und/oder Stromanschlusselemente (50, 19) nach vorne versetzt angeordnet ist und eine Aussparung (53) aufweist.

11. Spannungsgenerator, der ein Element nach einem beliebigen der vorhergehenden Ansprüche 1 bis 10 besitzt.

## FIG.1

## FIG.2a

FIG.2b

FIG.3

Fig. 4

Fig 10

FIG. 5

FIG.6

EP 1 760 883 B1

Fig. 7

13

Fig. 8a

Fig 8b

Fig. 8e

Fig 8c

Fig. 8d

Fig. 8f

EP 1 760 883 B1

EP 1 760 883 B1

Fig. 9

15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2823033